# FASCICULE DE BREVET EUROPEEN

(11) **EP 0 762 285 B1**
(45) Date de publication et mention de la délivrance du brevet: **31.10.2001**
(21) Numéro de dépôt: 96410088.7
(22) Date de dépôt: 06.08.1996
(51) Int. Cl.: G06F 11/267, G01R 31/28

(54) **Système électronique testable**
Elektronisches prüfbares System
Electronic testable system

(30) Priorité: 11.08.1995 FR 9509894
(43) Date de publication de la demande: 12.03.1997
(73) Titulaire: TEMENTO SYSTEMS, 38054 Grenoble Cedex 09 (FR)
(72) Inventeur: Deroux-Dauphin, Patrice, 38120 Saint Egreve (FR); François, Christian, 01390 Civrieux (FR)
(74) Mandataire: de Beaumont, Michel

(56) Documents cités:
- EP-A- 0 578 386
- US-A- 5 333 139
- AT & T TECHNICAL JOURNAL, vol. 73, no. 2, Mars 1994 - Avril 1994, NEW YORK US, pages 40-47, XP000445589 YAU, CHI W. ET AL.: "Boundary-scan testing for electronic subassemblies and systems"

## Description

La présente invention concerne un système électronique comprenant des composants dotés de possibilités de test.

La norme IEEE 1149.1-1990, intitulée "IEEE Standard Test Access Port and Boundary-Scan Architecture", définit une interface de test, appelée TAP ("Test Access Port"), dont doivent être munis des composants testables selon la norme. Cette interface comporte cinq signaux, à savoir un signal d'entrée de données de test TDI ("Test Data Input"), un signal de sortie de données de test TDO ("Test Data Output"), un signal de sélection de mode de test TMS ("Test Mode Select"), un signal d'horloge de test TCK, et un signal de remise à zéro de test TRST. Un composant doté d'une interface TAP est également muni d'une machine à états finis dont le comportement est spécifié par la norme pour, notamment, répondre à des instructions normalisées permettant de gérer les tests.

La norme IEEE définit également une architecture de test périphérique à utiliser en association avec des interfaces TAP.

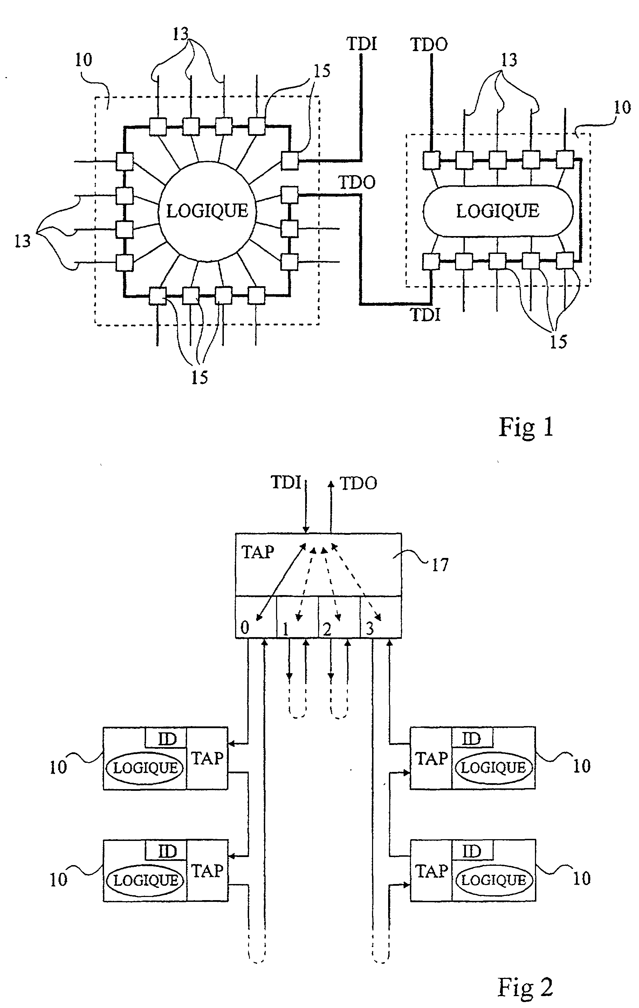

La figure 1 est destinée à illustrer une application de l'architecture de test périphérique à des composants 10, généralement des circuits logiques. Chaque broche 13 des composants 10 est reliée à la logique interne des composants par l'intermédiaire d'une cellule de test 15. En dehors des phases de test, les cellules 15 sont transparentes, c'est-à-dire qu'elles n'ont aucune influence sur les signaux transitant entre les broches 13 et la logique interne. Lors d'une phase de test périphérique, toutes les cellules 15 de chaque composant sont reliées les unes aux autres selon une chaîne qui se comporte comme un registre à décalage, chaque cellule 15 constituant une bascule de ce registre à décalage. Le signal TDI correspond à l'entrée du registre à décalage et le signal TDO à la sortie du registre à décalage. Ainsi, chaque composant conforme à la norme comporte deux broches réservées aux signaux TDI et TDO, mais comporte également trois broches supplémentaires réservées aux trois autres signaux TMS, TCK et TRST.

Comme cela est représenté à la figure 1, les cellules 15 de plusieurs composants peuvent être insérées dans une longue chaîne en connectant la broche TDO d'un premier composant à la broche TDI du composant suivant. La broche TDI du premier composant et la broche TDO du dernier composant permettent, respectivement, d'introduire en série des données dans les cellules 15 et de lire en série les données contenues dans les cellules 15, ceci étant cadencé par l'horloge de test TCK qui est fournie à tous les composants en même temps.

Avec cette architecture, on peut donc présenter des données, ou des vecteurs de test, aux entrées des circuits et récupérer les résultats correspondants aux sorties des circuits. Dans un circuit logique séquentiel, le signal d'horloge TCK permet de faire avancer l'état du circuit de plusieurs pas avant de relire les résultats.

L'architecture de test périphérique permet également de tester les liaisons entre composants sur un circuit imprimé.

Pour éviter la formation de chaînes de cellules particulièrement longues dans un système complexe, qui rendraient les tests particulièrement longs, les composants sont généralement répartis en sous-chaînes qui sont sélectionnées par des aiguillages conformes à la norme.

La figure 2 illustre l'utilisation d'un tel aiguillage 17. Comme les composants conformes à la norme, l'aiguillage 17 comporte aussi une interface TAP qui lui permet de recevoir une instruction de sélection de canal. L'aiguillage 17 représenté à la figure 2 comporte quatre canaux 0 à 3. Un tel aiguillage à 4 canaux est un composant disponible dans le commerce, par exemple le circuit de référence TI'ACT8997 fabriqué par la société Texas Instruments. De tels aiguillages peuvent être disposés en cascade pour augmenter le nombre de canaux.

L'aiguillage 17 est destiné à commuter les cinq signaux de l'interface TAP vers le canal 0 à 3 sélectionné. En pratique, le signal TRST de remise à zéro est fourni à chaque composant en même temps, et l'aiguillage 17 ne commute que les quatre signaux restants.

Ainsi, des sous-chaînes de composants 10 reliées respectivement aux canaux d'un aiguillage 17 peuvent être testées indépendamment les unes des autres, ce qui réduit le volume de vecteurs de test à fournir et de résultats à récupérer dans le cas courant où on ne teste que partiellement un système électronique.

Comme cela est représenté par la référence ID dans les composants 10 de la figure 2, la norme IEEE prévoit également de munir les composants conformes à cette norme d'un identificateur, comportant, par exemple, le type de composant et sa version. Chaque identificateur est en fait caractéristique du comportement de test du composant, c'est-à-dire des résultats de test que l'on doit obtenir en réponse aux vecteurs de test susceptibles d'être fournis au composant. Ainsi, un opérateur pourra initialement lire les identificateurs des composants d'une sous-chaîne et composer, à l'aide de ces identificateurs, une séquence de test adaptée.

Le test périphérique d'un composant est insuffisant pour déceler tous les défauts d'un composant. En effet, un composant peut comporter plusieurs niveaux logiques qui, par des erreurs successives, inversent une donnée un nombre pair de fois, de manière que le résultat correspond bien à celui qui est attendu, alors que le composant est défectueux. Ainsi, par extension du test périphérique, il est courant de réaliser les bascules d'un composant de manière qu'elles puissent être chaînées pendant une phase de test comme les cellules 15 pour y introduire des vecteurs de test et lire des résultats.

Toutefois, pour des composants d'une certaine complexité, le nombre de vecteurs de test et de résultats correspondants devient si considérable que de tels tests ne sont effectués qu'à l'échelle d'un seul composant ou, en tout cas, d'un faible nombre de composants. En effet, si l'on souhaite tester un système électronique comportant un grand nombre de composants complexes, il serait nécessaire de créer une base de données qui stocke, non seulement des vecteurs de test et les résultats correspondants pour chaque composant, mais aussi toutes les liaisons de test entre les composants, c'est-à-dire les chaînes et sous-chaînes de composants définies par les aiguillages. La gestion d'une telle base de données est d'autant plus complexe qu'un système électronique est généralement constitué de cartes que l'on peut souvent placer dans un connecteur quelconque d'un fond de panier (ce qui modifie bien entendu l'organisation des chaînes et sous-chaînes), et que chaque carte peut généralement être remplacée par une carte identique mais comportant des composants d'une version différente, ayant les mêmes fonctions que les composants de la carte précédente, mais dont les comportements de test sont différents (ce qui modifie les vecteurs de test et les résultats correspondants). Comme les manipulations de cartes dans un système électronique sont courantes, un tel système de test n'est pas envisageable, puisqu'à chaque changement de carte il faut effectuer une lourde opération de mise à jour de la base de données.

Un objet de la présente invention définie par les revendications indépendantes est de prévoir un système électronique testable conforme à la norme IEEE susmentionnée qui puisse avoir une structure de test complexe et évolutive tout en facilitant, ou même supprimant, les opérations de mise à jour de base de données en cas d'évolution.

Cet objet est atteint à l'aide d'une structure des éléments du système qui permet à un logiciel de test de parcourir le système de manière automatique pour "apprendre" l'organisation de ses chaînes et sous-chaînes de composants jusqu'à ce qu'il trouve un chemin vers un élément que l'on souhaite tester. Alors, on ne retient que ce chemin et on utilise des vecteurs de test et des résultats correspondants que l'on trouve dans une base de données grâce à des identificateurs relevés sur ce chemin.

Pour cela, le système électronique testable comprend des éléments testables munis d'interfaces de test normalisées selon la norme IEEE 1149.1 permettant d'organiser les éléments en chaînes qui se comportent comme des registres à décalage pour assurer l'échange d'informations de test, chaque élément étant, soit un composant possédant un identificateur caractéristique du comportement de test du composant et accessible par l'interface de test du composant, soit un aiguillage permettant d'organiser une chaîne en sous-chaînes individuellement sélectionnables par des canaux de l'aiguillage. Des aiguillages maîtres définissent des sous-ensembles respectifs d'éléments, un canal spécifique de chaque aiguillage maître, toujours le même pour un système donné, étant réservé pour accéder à un identificateur caractéristique de l'organisation de test du sous-ensemble associé.

Selon un mode de réalisation de la présente invention, les canaux de chaque aiguillage maître, autres que celui par lequel est accessible l'identificateur du sous-ensemble associé, sont reliés à des sous-chaînes pouvant contenir, selon une organisation quelconque, un ou plusieurs éléments ou aiguillages maîtres.

Selon un mode de réalisation de la présente invention, chaque sous-ensemble correspond à une carte de circuit imprimé possédant un connecteur qui relie son aiguillage maître à un canal d'un aiguillage maître d'une autre carte, toutes les cartes étant reliées, par interposition d'aiguillages maîtres, à un canal d'un aiguillage maître d'une unique carte d'interface par l'intermédiaire de laquelle on effectue le test du système.

Selon un mode de réalisation de la présente invention, le système comprend une base de données associant :
à chaque identificateur distinct de composant, un ensemble de vecteurs de test et de résultats attendus correspondants ; et
à chaque identificateur distinct de sous-ensemble ou de carte, des informations indicatives de l'organisation des sous-chaînes de la carte, un ensemble de vecteurs de test associé à chaque sous-chaîne de la carte, et des résultats attendus correspondants.

La présente invention concerne aussi un procédé d'exploitation du système ci-dessus comprenant, pour tester une carte prédéterminée, l'étape consistant à parcourir le graphe constitué par les liaisons entre cartes jusqu'au moment où on trouve un chemin vers la carte prédéterminée, ce parcours étant effectué en parcourant chaque carte que l'on trouve reliée à une carte précédente grâce aux informations associées, dans la base de données, à l'identificateur de la carte précédente.

Selon un mode de réalisation de la présente invention, le graphe est parcouru selon un chemin eulérien permettant de relier toutes les cartes, l'algorithme d'établissement du chemin eulérien étant modifié de manière que le chemin puisse passer plus d'une fois par un même canal.

Selon un mode de réalisation de la présente invention, le procédé comprend l'étape consistant à tester la carte prédéterminée par l'utilisation de vecteurs de test associés, dans la base de données, à l'identificateur de la carte prédéterminée, ces vecteurs étant fournis, et les résultats correspondants lus, par le chemin trouvé.

Selon un mode de réalisation de la présente invention, le procédé comprend les étapes suivantes :
- chercher un composant prédéterminé en lisant les identificateurs des composants des sous-chaînes de la carte prédéterminée ; et
- tester le composant prédéterminé par l'utilisation de vecteurs de test associés, dans la base de données, à l'identificateur du composant.

Ces objets, caractéristiques et avantages, ainsi que d'autres de la présente invention seront exposés en détail dans la description suivante de modes de réalisation particuliers faite à titre non limitatif en relation avec les figures jointes parmi lesquelles :
la figure 1, précédemment décrite, représente schématiquement une organisation de test périphérique selon la norme IEEE 1149.1-1990 ;
la figure 2, précédemment décrite, représente une subdivision de composants à tester en plusieurs sous-chaînes accessibles par un aiguillage classique ; et
la figure 3 représente schématiquement et partiellement un système électronique testable selon la présente invention.

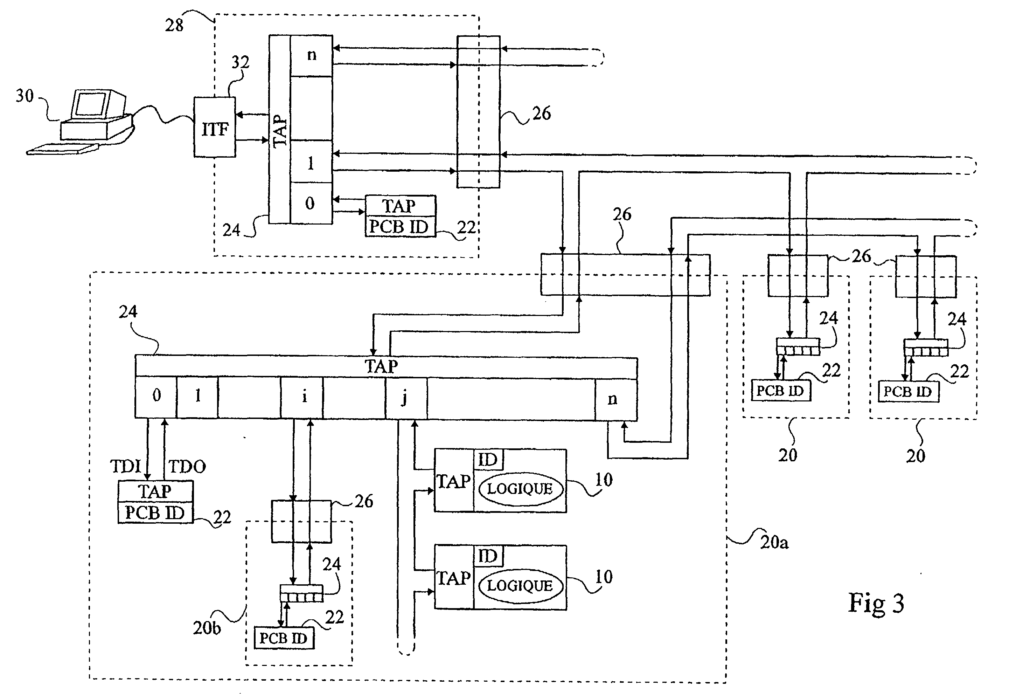

Dans la figure 3, selon la présente invention, les composants testables 10 sont répartis en sous-ensembles 20, de préférence des cartes de circuit imprimé. L'une des cartes, désignée 20a, est représentée de manière plus détaillée que les autres. Selon une caractéristique essentielle de l'invention, chaque carte comporte un identificateur de carte 22 qui est accessible par un canal spécifique, toujours le même pour un système donné, par exemple 0, d'un aiguillage maître 24. Cet aiguillage maître constitue, de préférence, le seul accès de test à la carte.

Chaque aiguillage maître 24 comporte un nombre quelconque de canaux affectés tous, sauf le canal 0, à des éléments quelconques pouvant être des sous-chaînes de composants (ce qui est représenté pour le canal j), d'autres aiguillages, et même, comme cela est représenté pour les canaux i et n, des aiguillages maîtres 24 d'autres cartes, telles qu'une carte fille pour le canal i, ou une chaîne de cartes reliées à un même fond de panier pour le canal n. Comme cela est classique, les cartes sont reliées entre elles ou au fond de panier par des connecteurs 26 qui transmettent aussi les cinq signaux de test.

On réalise ainsi une organisation de test hiérarchique quelconque où une carte se trouve connectée dans une chaîne de cartes de même niveau hiérarchique, cette chaîne étant desservie par un canal de l'aiguillage maître d'une carte de niveau hiérarchique supérieur (bien entendu, une sous-chaîne peut ne comprendre qu'une seule carte, comme c'est le cas du canal i dans la carte 20a). Toutes les chaînes et sous-chaînes du système convergent, par aiguillages maîtres interposés, vers les canaux d'un aiguillage maître 24 d'une carte d'interface unique 28. Comme les cartes 20, la carte d'interface 28 est munie d'un identificateur de carte 22, accessible par le canal spécifique 0 de son aiguillage maître 24. Ainsi, un système informatique 30, relié à l'aiguillage maître de la carte 28 par un circuit d'interface adapté 32, peut accéder à l'ensemble du système à tester.

Chaque identificateur de carte 22 est caractéristique de l'organisation des sous-chaînes de la carte, de manière qu'on puisse reconstituer cette organisation par référence à une base de données. Par exemple, pour la carte 20a, l'identificateur 22 permettra de retrouver des informations dans la base de données qui indiquent que le canal i de l'aiguillage maître est relié à une autre carte 20b, que le canal j est relié à une sous-chaîne de composants et le nombre de composants de cette sous-chaîne, et que le canal n est relié à une sous-chaîne de cartes. Ainsi, la base de données contient un ensemble de "morceaux" d'architecture, correspondant aux organisations des cartes, qui sont assemblés temporairement, de la manière décrite ci-après, pour constituer un chemin vers une carte à tester.

Pour qu'un identificateur de carte 22 soit accessible par l'intermédiaire de l'aiguillage maître associé, cet identificateur doit se comporter comme un composant testable par une interface TAP normalisée. Chaque identificateur 22 est contenu, par exemple, dans une mémoire ROM ou EPROM dont les bits sont rendus accessibles en série par des signaux TDI et TDO à l'aide d'un circuit de commande qui gère la mémoire et se comporte comme la machine d'états définie par la norme IEEE.

Pour accéder à une carte particulière du système de la figure 3, le système informatique 30 procède de la manière suivante. Il commence par lire l'identificateur 22 de la carte d'interface 28 et, par référence à la base de données, acquérir l'organisation des canaux de l'aiguillage maître 24, c'est-à-dire, dans le cas particulier de la carte d'interface 28, combien de cartes sont connectées à chacun des canaux 1 à n. Ensuite, il parcourt successivement les canaux de l'aiguillage maître (sauf le canal 0) de cette carte. Le système a mémorisé pour chaque canal la présence d'une sous-chaîne de cartes. Si un canal n'a pas encore été parcouru, le système n'a aucune information sur les cartes associées, sauf leur nombre et que leurs identificateurs 22 sont accessibles par le canal spécifique 0. Il descend alors d'un niveau hiérarchique en sélectionnant l'une des cartes inconnues, par exemple 20a, en lisant son identificateur 22. Par référence à la base de données, il acquiert l'organisation de la carte 20a, notamment le fait que de nouvelles cartes inconnues sont connectées aux canaux i et n de son aiguillage. Le système sélectionne le premier canal i sur lequel il y a une seule carte 20b, et lit son identificateur 22. Cet identificateur 22 indiquera, par exemple, qu'il y a encore des cartes à un niveau inférieur.

De façon générale, lorsque toutes les cartes reliées à une carte de niveau hiérarchique h ont été parcourues, le système informatique se met à parcourir la carte suivante de niveau h, reliée à une même carte de niveau (supérieur) h-1. S'il n'y a plus de cartes de niveau h reliées à cette carte de niveau h-1, le système se met à parcourir la carte suivante de niveau h-1, reliée à une même carte de niveau h-2... Ceci jusqu'à ce que le système informatique trouve la carte à tester. Au fur et à mesure que le système informatique parcourt la hiérarchie, il peut effacer de sa mémoire les chemins qui n'aboutissent pas, de manière que, lorsque la carte à tester est trouvée, il ne subsiste que le strict chemin nécessaire à atteindre cette carte.

Pour illustrer le procédé utilisé pour parcourir le système à tester, on peut considérer le graphe hiérarchique constitué par les interconnexions entre cartes comme un labyrinthe que l'on parcourt en gardant toujours sa droite, dans le but de le parcourir en totalité. Ou encore, le graphe est parcouru selon un chemin eulérien qui, en principe, permet de relier tous les noeuds constitués par les aiguillages maîtres ou les cartes. L'algorithme (de Roy Modifié) qui permet de trouver ce chemin est toutefois modifié de manière que l'on puisse parcourir plusieurs fois un même chemin, c'est-à-dire un canal d'aiguillage maître.

Si le graphe hiérarchique ne comporte pas de boucle (ce qui devrait normalement être le cas), cela permet de le parcourir entièrement de manière fiable. Par contre, si le graphe comporte des boucles, on doit prendre une précaution supplémentaire pour éviter le risque de tourner en rond en rencontrant une boucle dans le parcours.

En pratique, pour mémoriser le chemin emprunté, on mémorise une succession de nombres affectés aux cartes rencontrées. Par exemple, lors d'un parcours, on a stocké les nombres successifs A-B-C-D-E-C-D-E. La répétition de la séquence C-D indique que l'on est entré dans une boucle (et si l'on n'en sort pas, on parcourt la séquence C-D-E sans cesse). Cette boucle est détectée en comparant chaque couple de deux nombres successifs (C-D) aux couples de nombres précédents. Si le couple est retrouvé dans les couples précédents, on se trouve dans une boucle. Dans l'exemple ci-dessus, l'identificateur de la carte C indique, par référence à la base de données, qu'elle est reliée à des cartes de niveau inférieur X, D et Y. Alors, au lieu de passer de la carte C à la carte D, on décide de passer de la carte C à une carte non encore parcourue, par exemple Y. Alors, à la place de la deuxième séquence C-D-E ci-dessus, on a la séquence C-D-Y.

Pour tester un composant de la carte, il y a deux possibilités. Dans un premier cas, on ne connaît le composant à tester que par son type (contenu dans l'identificateur du composant). Alors, le système informatique parcourt successivement les canaux d'aiguillage auxquels sont reliées des sous-chaînes de composants en lisant les identificateurs des composants. Les canaux reliés à des sous-chaînes de composants, ainsi que le nombre de composants de ces sous-chaînes, sont fournis par les informations de la base de données, associées à l'identificateur de carte 22. Lorsque le composant à tester a été trouvé, on a également trouvé le chemin permettant de le tester et l'identificateur du composant permet de trouver dans la base de données les vecteurs de test et les résultats attendus à utiliser. Dans un deuxième cas, on connaît l'emplacement du composant à tester dans une sous-chaîne de la carte, ce qui permet de déduire directement son chemin de test.

Pour tester les liaisons d'une carte, la base de données associe à chaque identificateur de carte 22 un ensemble de vecteurs de test à écrire dans les cellules périphériques des composants, et un ensemble de résultats correspondants à lire dans les cellules périphériques.

Ces procédures de parcours et de test s'appliquent bien entendu au test de plusieurs composants à la fois ou plusieurs cartes à la fois.

Un système testable selon l'invention peut être tout à fait quelconque et évolutif. En effet, toute carte peut comporter un aiguillage maître dont plusieurs canaux sont destinés à être reliés à d'autres cartes respectives. Il n'est pas nécessaire qu'une carte soit effectivement reliée à un tel canal, car, en sélectionnant un canal d'aiguillage inutilisé, l'aiguillage se comporte comme une chaîne à une seule bascule contenant un "1", ce qui signale l'absence de connexion. Par contre, si un canal est destiné à être relié à une chaîne de cartes, chacune des cartes de la chaîne doit être présente pour assurer la continuité de la chaîne.

Des cartes peuvent être retirées ou ajoutées au système sans qu'il soit nécessaire de mettre à jour la base de données, à condition que les identificateurs d'une nouvelle carte et de ses composants soient répertoriés dans la base de données. Si ce n'est-pas le cas, il suffit de compléter la base de données sans se soucier des interconnexions de la nouvelle carte avec le reste du système.

L'organisation quelconque, notamment des aiguillages maîtres 24, fournit une grande souplesse de réalisation aux concepteurs des cartes. En effet, les signaux de test, qui ne sont pas essentiels au fonctionnement d'une carte, sont toujours routés en dernier. Dans des cartes denses, ce routage devient classiquement particulièrement difficile, voire impossible. Le fait de pouvoir disposer des canaux d'aiguillage de manière quelconque facilite notablement cette tâche.

Les vecteurs de test et les résultats attendus sont obtenus de manière classique en exploitant de manière automatisée les plans informatiques ayant permis la réalisation des cartes ou des composants.

## Revendications

1. Système électronique testable comprenant des éléments testables munis d'interfaces de test normalisées selon la norme IEEE 1149.1 permettant d'organiser les éléments en chaînes qui se comportent comme des registres à décalage pour assurer l'échange d'informations de test, chaque élément étant, soit un composant (10) possédant un identificateur caractéristique du comportement de test du composant et accessible par l'interface de test du composant, soit un aiguillage permettant d'organiser une chaîne en sous-chaînes individuellement sélectionnables par des canaux de l'aiguillage, **caractérisé en ce qu'**il comprend des aiguillages maîtres (24) qui définissent des sous-ensembles (20) respectifs d'éléments, un canal spécifique de chaque aiguillage maître, toujours le même pour un système donné, étant réservé pour accéder à un identificateur (22) caractéristique de l'organisation de test du sous-ensemble associé.

2. Système électronique testable selon la revendication 1, **caractérisé en ce que** les canaux de chaque aiguillage maître (24), autres que celui par lequel est accessible l'identificateur du sous-ensemble associé, sont reliés à des sous-chaînes pouvant contenir, selon une organisation quelconque, un ou plusieurs éléments ou aiguillages maîtres.

3. Système électronique testable selon la revendication 1, **caractérisé en ce que** chaque sous-ensemble correspond à une carte de circuit imprimé (20) possédant un connecteur (26) qui relie son aiguillage maître (24) à un canal d'un aiguillage maître d'une autre carte, toutes les cartes étant reliées, par interposition d'aiguillages maîtres, à un canal d'un aiguillage maître d'une unique carte d'interface (28) par l'intermédiaire de laquelle on effectue le test du système.

4. Système électronique testable selon la revendication 3, **caractérisé en ce qu'**il comprend une base de données associant :
à chaque identificateur distinct de composant (10), un ensemble de vecteurs de test et de résultats attendus correspondants ; et
à chaque identificateur (22) distinct de sous-ensemble ou de carte (20), des informations indicatives de l'organisation des sous-chaînes de la carte, un ensemble de vecteurs de test associé à chaque sous-chaîne de la carte, et des résultats attendus correspondants.

5. Procédé d'exploitation d'un système électronique testable selon la revendication 4, **caractérisé en ce qu'**il comprend, pour tester une carte prédéterminée, l'étape consistant à parcourir le graphe constitué par les liaisons entre cartes (20) jusqu'au moment où on trouve un chemin vers la carte prédéterminée, ce parcours étant effectué en parcourant chaque carte que l'on trouve reliée à une carte précédente grâce aux informations associées, dans la base de données, à l'identificateur (22) de la carte précédente.

6. Procédé d'exploitation selon la revendication 5, **caractérisé en ce que** le graphe est parcouru selon un chemin eulérien permettant de relier toutes les cartes (20), l'algorithme d'établissement du chemin eulérien étant modifié de manière que le chemin puisse passer plus d'une fois par un même canal.

7. Procédé d'exploitation selon la revendication 5, **caractérisé en ce qu'**il comprend l'étape consistant à tester la carte prédéterminée par l'utilisation de vecteurs de test associés, dans la base de données, à l'identificateur (22) de la carte prédéterminée, ces vecteurs étant fournis, et les résultats correspondants lus, par le chemin trouvé.

8. Procédé d'exploitation selon la revendication 5, **caractérisé en ce qu'**il comprend les étapes suivantes :
- chercher un composant prédéterminé (10) en lisant les identificateurs des composants des sous-chaînes de la carte prédéterminée ; et
- tester le composant prédéterminé par l'utilisation de vecteurs de test associés, dans la base de données, à l'identificateur du composant.

## Patentansprüche

1. Prüfbares elektronisches System mit prüfbaren Elementen, die mit nach der Norm IEEE 1149.1 genormten Schnittstellen ausgerüstet sind, die es erlauben, die Elemente in Ketten zu organisieren, die sich wie Schieberegister verhalten, um den Austausch von Prüfinformationen sicherzustellen, wobei jedes Element entweder eine Komponente (10) mit einem Identifizierer, der charakteristisch für das Prüfverhalten der Komponente ist und auf den durch die Prüfschnittstelle der Komponente zugegriffen werden kann, oder ein Verteiler ist, mit dem eine Kette aus Unterketten organisiert werden kann, die individuell durch Kanäle des Verteilers ausgewählt werden können, **dadurch gekennzeichnet, daß** es Master-Verteiler (24) aufweist, die entsprechende Unter-Ensembles (20) aus Elementen definieren, wobei ein spezifischer Kanal jedes Master-Verteilers, der für ein gegebenes System stets derselbe ist, reserviert ist für den Zugriff auf einen Identifizierer (22), der für die Prüforganisation des zugeordneten Unter-Ensembles charakteristisch ist.

2. Prüfbares elektronisches System nach Anspruch 1, **dadurch gekennzeichnet, daß** die Kanäle jedes Master-Verteilers (24), die unterschiedlich zu dem sind, über den auf den Identifizierer des zugeordneten Unter-Ensembles zugegriffen wird, jeweils mit Unterketten verbunden sind, die nach einer beliebigen Organisation ein oder mehrere Elemente oder Master-Verteiler enthalten können.

3. Prüfbares elektronisches System nach Anspruch 1, **dadurch gekennzeichnet, daß** jedes Unter-Ensemble einer gedruckten Schaltungskarte (20) entspricht, die einen Stecker (26) besitzt, der seinen Master-Verteiler (24) mit einem Kanal eines Master-Verteilers einer anderen Karte verbindet, wobei alle Karten über die Zwischenschaltung von Master-Verteilern mit einem Kanal eines Master-Verteiler einer einzigen Schnittstellenkarte (28) verbindet, über die das System geprüft wird.

4. Prüfbares elektronisches System nach Anspruch 3, **dadurch gekennzeichnet, daß** es eine Datenbasis aufweist, die
jeden unterschiedlichen Identifizierer einer Komponente (10) ein Vektor-Ensemble für die Prüfung und die entsprechenden erhaltenen Resultate zuordnet; und
jedem unterschiedlichen Identifizierer (22) eines UnterEnsembles oder der Karte (20) Informationen zuordnet, die die Organisation der Unterketten der Karten angibt, ferner ein Vektor-Ensemble der Prüfung, das jeder Unterkette der Karte und entsprechenden erhaltenen Resultaten zugeordnet ist.

5. Verfahren zur Verwendung eines prüfbaren elektronischen Systems nach Anspruch 4, **dadurch gekennzeichnet, daß** es für die Überprüfung einer vorbestimmten Karte den Schritt aufweist, der darin besteht, den durch die Verbindungen zwischen den Karten gebildeten Graphen bis zu dem Moment zu durchlaufen, wo ein Weg zur vorbestimmten Karte gefunden wird, wobei dieses Durchlaufen dadurch bewirkt wird, jede Karte zu durchlaufen, die als mit einer vorhergehenden Karte verbunden aufgrund der Informationen gefunden wird, die in der Datenbasis dem Identifizierer (22) der vorhergehenden Karte zugeordnet sind.

6. Verfahren nach Anspruch 5, **dadurch gekennzeichnet, daß** der Graph längs eines Euler'schen Wegs durchlaufen wird, mit dem alle Karten (20) miteinander verbunden werden können, wobei der Algorithmus zum Einrichten des Euler'schen Wegs derart modifiziert wird, daß der Weg mehr als einmal durch ein und denselben Kanal laufen kann.

7. Verfahren nach Anspruch 5, **dadurch gekennzeichnet, daß** er den Schritt umfaßt, die vorgehende Karte durch die Verwendung von Prüfvektoren zu prüfen, die in der Datenbasis dem Identifizierer (22) der vorbestimmten Karte zugeordnet sind, wobei diese Vektoren und die korrespondierenden ausgelesenen Ergebnisse durch den gefundenen Weg gebildet werden.

8. Verfahren nach Anspruch 5, **dadurch gekennzeichnet, daß** es folgende Schritte enthält:
- Suchen einer vorbestimmten Komponente (10), indem die Identifizierer der Komponenten der Unterketten der vorbestimmten Karte gelesen werden; und
- Prüfen der vorbestimmten Komponente durch die Verwendung von Prüfvektoren, die in der Datenbasis dem Identifizierer der Komponente zugeordnet sind.

## Claims

1. A testable electronic system including testable elements having test interfaces according to the standard IEEE 1149.1 for organizing the elements in chains which behave like shift registers to ensure the exchange of test information, each element being either a component (10) including an identifier characterizing the behavior of the test of the component and accessible by the test interface of the component, or a switch for organizing a chain in sub-chains which can be individually selected through channels of the switch, **characterized in that** it includes master switches (24) which define respective sub-sets (20) of elements, a specific channel of each master switch, always the same one for a given system, being reserved to access an identifier (22) characterizing the test organization of the associated sub-set.

2. The system of claim 1, **characterized in that** the channels of each master switch (24), other than the reserved one, are connected to sub-chains that can include, in an arbitrary organization, one or more elements or master switches.

3. The system of claim 1, **characterized in that** each sub-set corresponds to a printed circuit board (20) including a connector (26) which connects its master switch (24) to a channel of a master switch of another board, all the boards being connected, through interposed master switches, to a channel of a master switch of a single interface board (28) through which the system is tested.

4. The system of claim 3, **characterized in that** it includes a data base associating:
with each distinct component identifier (10), a set of test vectors and of corresponding expected results; and
with each distinct sub-set or board (20) identifier (22), information indicating the organization of the board's sub-chains, a set of test vectors associated with each sub-chain of the board, and the corresponding expected results.

5. A method of use of the testable electronic system of claim 4, **characterized in that** it includes, to test a predetermined board, the step of scanning the graph formed by the connections between boards (20) until a path to the predetermined board is found, said graph being scanned by scanning each board that is found connected to a preceding board by using the information associated, in the data base, with the identifier (22) of the preceding board.

6. The method of claim 5, **characterized in that** the graph is scanned along an Euler path for linking all the boards (20) together, the algorithm for establishing the Euler path being modified so that the Euler path can pass more than once through a same channel.

7. The method of claim 5, **characterized in that** it includes the step of testing the predetermined board by using vectors associated, in the data base, with the identifier (22) of the predetermined board, said vectors being provided, and the corresponding results being retrieved through the path that was found.

8. The method of claim 5, **characterized in that** it includes the following steps:
- searching for a predetermined component (10) by reading the identifiers of the components of the sub-chains of the predetermined board; and
- testing the predetermined component by using test vectors associated, in the data base, with the component's identifier.
